# EUROPÄISCHE PATENTSCHRIFT

(11) **EP 0 692 719 B1**
(45) Veröffentlichungstag und Bekanntmachung des Hinweises auf die Patenterteilung: **16.08.2000**
(21) Anmeldenummer: 95109888.8
(22) Anmeldetag: 24.06.1995
(51) Int. Cl.: G01R 33/30

(54) **Mischvorrichtung zur Durchmischen von Fluiden in einer Hochdruck-NMR-Messeinrichtung**
Device for mixing fluids in a high pressure NMR measuring device
Dispositif pour le mélange de fluides dans un dispositif de mesure RMN à haute pression

(30) Priorität: 14.07.1994 DE 4424843
(43) Veröffentlichungstag der Anmeldung: 17.01.1996
(73) Patentinhaber: Bruker AG, 8117 Fällanden (CH)
(72) Erfinder: Favre, Patrick, CH-1010 Lausanne (CH); Frei, Urban, CH-1018 Lausanne (CH); Marek, Daniel, CH-5515 Möriken (CH); Metz, François, F-69540 Irigny (FR)
(74) Vertreter: KOHLER SCHMID + PARTNER

(56) Entgegenhaltungen:
- EP-A- 0 136 642
- EP-A- 0 164 801
- JOURNAL OF MAGNETIC RESONANCE, Bd. 71, 1987 Seiten 480-484, D.G. VANDER VELDE, J. JONAS: 'A High-Pressure Probe for NMR Studies of Homogeneous Catalysts'
- REVIEW OF SCIENTIFIC INSTRUMENTS, Bd. 65, April 1994 Seiten 882-886, A. ZAHL ET AL.: 'A high-pressure NMR probehead for measurements at 400 MHz'

## Beschreibung

Die Erfindung betrifft eine Kernspinresonanz (NMR)-Meßeinrichtung mit einer Hauptfeld-Magnetspule zur Erzeugung eines parallel zu einer zentralen Achse der Hauptfeld-Magnetspule verlaufenden homogenen statischen Magnetfeldes in einem Meßvolumen innerhalb der Meßprobe und mit einer Mischvorrichtung zum Durchmischen von insbesondere flüssigen und/oder gasförmigen Meßproben, die eine koaxial zur zentralen Achse der Hauptfeld-Magnetspule angeordnete und in axialer Richtung der zentralen Achse bewegliche Stange enthält, die an ihrem einen Ende einen in die flüssige und/oder gasförmige Meßprobe ragenden Kolben aufweist, und die mit Hilfe einer mit ihrem von der Melprobe abgewandten Ende verbundenen Antriebsspule bei Stromdurchfluß durch die Antriebsspule in axialer Richtung bewegt wird, wobei ein Federelement vorgesehen ist, welches die Stange in eine Ruheposition zurücktreibt.

Eine NMR-Meßeinrichtung mit einer solchen Mischvorrichtung ist beispielsweise bekannt aus dem Artikel "A High-Pressure Probe for NMR Studies of Homogeneous Catalysis" von Velde und Jonas in "Journal of Magnetic Resonance", Nr. 71, Seiten 480-484, 1987.

Die dort beschriebene Hochdruck-NMR-Meßeinrichtung dient zur Untersuchung von chemischen Reaktionen, die in einem gesättigten Gas-Flüssigkeitsgemisch stattfinden, mit Hilfe von Kernspinresonanz bei hohen Drücken. Aus der Theorie der Partialdrücke ist bekannt, daß sich in der Flüssigkeit ein um so höherer Gasteil lösen läßt, je größer der außen angelegte Druck ist. Durch die stattfindenden chemischen Reaktionen wird der gesättigte Zustand des Gemisches gestört und muß ständig von neuem wieder eingestellt werden.

Der gesättigte Zustand ist ein Gleichgewichtszustand, der sowohl vom Druck als auch von der Temperatur abhängt. Deshalb benötigt man für diese Art von Messungen sowohl eine variable Konstantdruck-Vorrichtung im Bereich von 1 bis 1000 bar als auch eine Temperaturregelung (üblicherweise im Bereich von -20°C bis +180°C).

Um die zu beobachtende chemische Reaktion quantitativ erfassen zu können, ist es notwendig, daß die Reaktion gleichmäßig und gleichzeitig innerhalb der gesamten Flüssigkeit stattfindet. Das Gas und die Flüssigkeit müssen deshalb möglichst schnell und möglichst gleichmäßig miteinander vermischt werden, und zwar noch bevor die Reaktion richtig angefangen hat. Ein aktiver Durchmischungsvorgang ist daher für derartige Untersuchungen unumgänglich. Ohne aktiven Durchmischungsvorgang würde der Mischprozeß lediglich durch Diffusion stattfinden, also sehr langsam ablaufen. Die Größenordnung bis zur Erreichung eines gesättigten Zustandes durch bloße Diffusion beträgt mehrere Tage. Ein aktiver Durchmischungsvorgang hingegen verkürzt die erforderliche Mischzeit um viele Größenordnungen; der gesättigte Zustand wird in nur 10 bis 60 Sekunden erreicht.

Der Durchmischungsvorgang sollte vorzugsweise innerhalb des Hauptfeld-Magneten der NMR-Meßeinrichtung stattfinden, um keine zusätzliche Zeit zu verlieren. Dadurch ist die Einrichtung in kürzester Zeit wieder meßbereit und somit imstande, den zeitlichen Verlauf der chemischen Reaktion exakt zu erfassen. Während des NMR-Meßvorganges, der bei konstantem Druck stattfindet, muß die Durchmischung von Zeit zu Zeit wiederholt werden. Dies ist notwendig, weil durch die chemische Reaktion Gas verbraucht wird und daher neues Gas hinzugemischt werden muß, um den geforderten Sättigungszustand wiederherzustellen. Nur ein in dieser Weise ablaufender Meßvorgang führt zu zuverlässigen, reproduzierbaren Meßwerten des zeitlichen Reaktionsablaufes.

Derartige zeitliche Reaktionsabläufe können bei unterschiedlichen Drücken und Temperaturen, die während des Meßvorganges jeweils konstant gehalten werden, gemessen werden.

Die Mischvorrichtung selbst sollte vorzugsweise nicht magnetisch sein, damit die erforderliche extrem hohe Homogenität des von der Hauptfeldspule erzeugten Magnetfeldes für die NMR-Messung nicht aufgrund von überlagerten Magnetfeldern aus der Mischvorrichtung verschlechtert wird. Ferromagnetische oder gar permanentmagnetische Materialien müssen daher in der Mischvorrichtung unbedingt vermieden werden, oder wenn es nicht anders geht, räumlich möglichst weit getrennt vom magnetischen Zentrum der NMR-Meßeinrichtung angeordnet werden.

Eine bekannte Durchmischungsmethode besteht darin, die Meßprobe zuerst aus dem Hauptfeld-Magneten zu entfernen, zu schütteln und anschließend wieder in den Hauptfeld-Magneten einzubringen, um die NMR-Messung durchzuführen. Ein Nachteil der bekannten Methode liegt darin, daß die Meßprobe nach dem Schütteln bereits zu reagieren beginnt, bevor die NMR-Messung überhaupt begonnen werden kann. Zudem verändert sich bei diesem Vorgang die Temperatur der Meßprobe, die nachträglich wieder auf den gewünschten konstanten Wert gebracht werden muß.

Bei einer anderen bekannten Meßmethode werden Elektromotore mit Permanentmagneten verwendet, um mechanische Schüttelbewegungen zu erzeugen. Ein solches Verfahren, wie es beispielsweise in dem eingangs zitierten Artikel in JMR 71, 480-484 (1987) beschrieben ist, weist jedoch eine Reihe von schwerwiegenden Nachteilen auf:

Die in dem Elektromotor enthaltenen ferro- und permanentmagnetischen Materialien verzerren das homogene Feld des NMR-Hauptfeld-Magneten. Zudem erzeugt der permanentmagnetische Anteil zusätzliche inhomogene Felder.

Magnetische Kräfte zwischen dem Elektromotor und dem supraleitenden Magnetsystem können zu mechanischen Stabilitätsproblemen führen, falls beide zu nahe beisammen sind.

Damit die gegenseitigen Beeinflussungen zwischen dem Elektromotor und dem NMR-Hauptfeld-Magneten möglichst klein gehalten werden, muß der Elektromotor räumlich sehr weit entfernt vom magnetischen Zentrum des NMR-Hauptfeld-Magneten angebracht werden. Dies führt unweigerlich zu einer sehr großen und unhandlichen Durchmischungseinrichtung.

Falls der Elektromotor außerhalb des Hochdruckgebietes arbeitet, in welchem sich die NMR-Meßprobe befindet, sind mechanisch bewegliche Hochdruck-Durchführungen zur Übertragung der Schüttelbewegung erforderlich. Letztere sind äußerst schwierig herzustellen, unzuverlässig und bei hohen Drücken kaum noch zu realisieren. Andererseits führt ein im Hochdruckgebiet zusammen mit der Meßprobe angeordneter Elektromotor ebenfalls zu enormen technischen Problemen.

Aufgabe der vorliegenden Erfindung ist es demgegenüber, eine NMR-Meßeinrichtung mit einer Mischvorrichtung der eingangs beschriebenen Art vorzustellen, bei der das homogene Magnetfeld des NMR-Hauptfeld-Magneten während der NMR-Meßung nicht beeinträchtigt wird, bei der keine mechanischen Kräfte zwischen der Mischvorrichtung und dem NMR-Hauptfeld-Magneten entstehen, die räumlich in der Nähe des NMR-Hauptfeld-Magneten angeordnet sein kann, und die insbesondere problemlos in einem Hochdruckgebiet arbeiten kann, wodurch die Gesamtapparatur besonders kompakt gestaltet werden kann.

Erfindungsgemäß wird diese Aufgabe auf ebenso überraschend einfache wie wirkungsvolle Art und Weise dadurch gelöst, daß die Antriebsspule axialsymmetrisch ist und koaxial mit der zentralen Achse der Hauptfeld-Magnetspule außerhalb des Meßvolumens angeordnet, mit Hilfe des Federelementes koaxial zur zentralen Achse der Hauptfeld-Magnetspule beweglich befestigt und starr mit der Stange verbunden ist, wobei die stromdurchflossene Antriebsspule durch eine Kraft bewegt wird, die die axiale Komponente des von der Hauptfeld-Magnetspule erzeugten Magnetfeldes in Verbindung mit einem axialen Feldgradienten auf die Antriebsspule ausübt.

Bei der Mischvorrichtung in der erfindungsgemäßen NMR-Meßeinrichtung werden durch die Anordnung der Antriebsspule im inhomogenen Teil des NMR-Magnetfelds die mechanischen Kräfte zum Antrieb der beweglichen Stange mit Hilfe des als Stator wirkenden NMR-Magnetfeld bei Stromfluß durch die Antriebsspule erzeugt, ohne daß magnetische Teile wie bei einem herkömmlichen Elektromotor erforderlich sind. Die axial auf die stromdurchflossene Antriebsspule im inhomogenen Magnetfeld wirkende Lorentzkraft ist in etwa gleich dem Produkt aus Spulenstrom, Feldgradient und Feldstärke. Mit "Feld" ist die axiale Feldkomponente des Magneten gemeint. Nach Abschalten des Stromes durch die Antriebsspule wird durch die Mischvorrichtung keinerlei Einwirkung auf das homogene Magnetfeld im Meßvolumen der NMR-Anordnung ausgeübt. Daher kann die Mischvorrichtung auch in unmittelbarer Nähe des Meßvolumens angeordnet sein, was eine besonders kompakte Bauform der Gesamtanlage ermöglicht.

Die Verwendung des von der Hauptfeld-Magnetspule in einer NMR-Anordnung erzeugten Magnetfeldes als Statorfeld in einem eisenlosen Gleichstrom-Rotationsmotor durch entsprechende Anordnung einer rotierenden Spule im Magnetfeld ist aus der EP 0 136 642 B1 an sich bekannt. Die dort beschriebene Anordnung dient allerdings nicht zur Erzeugung einer linearen Mischbewegung in einem Hochdruck-Spektrometer, und ist bezüglich der Mischvorrichtung mit den eingangs erwähnten Merkmalen gattungsfremd.

Bei einer bevorzugten Ausführungsform bildet das Gehäuse der NMR-Meßeinrichtung eine Hochdruckkammer und die Mischvorrichtung ist ebenso wie die Meßprobe im Hochdruckbereich der Hochdruckkammer angeordnet. Damit kann der entscheidende Vorteil der erfindungsgemäß modifizierten Mischvorrichtung, daß sie nämlich ohne Beeinträchtigung der Homogenität des vom Grundfeld-Magneten erzeugten Magnetfeldes in der Nähe der Meßprobe angeordnet werden kann, besonders wirkungsvoll zum Bau eines sehr kompakten, in seiner axialen Länge gegenüber bekannten Anordnungen stark verkürzten NMR-Hochdruck-Spektrometers ausgenutzt werden.

Vorteilhaft ist eine Ausführungsform , bei der einer der beiden zur Stromversorgung der Antriebsspule erforderlichen elektrischen Anschlüsse durch das Federelement gebildet wird, welches bei dieser Ausführungsform dann zwei völlig unterschiedliche Funktionen gleichzeitig übernimmt.

Insbesondere kann bei einer weiteren Ausführungsform das Federelement eine Rückstellfeder sein, wobei die Antriebsspule bei Stromdurchfluß die Rückstellfeder entgegen der Federkraft vom Gehäuse wegzieht und dadurch spannt. Sobald kein Strom mehr durch die Antriebsspule fließt, zieht die Rückstellfeder die Antriebsspule samt Stange in axialer Richtung von der Meßprobe weg.

Besonders bevorzugt ist eine Ausführungsform , bei der koaxial zur Antriebsspule eine Meßspule zur Detektion der momentanen axialen Position der Antriebsspule vorgesehen ist. Die Antriebsspule induziert dann auf ihrer Bahnbewegung ein von ihrer axialen Position abhängiges Strom- bzw. Spannungssignal in der Meßspule. Damit kann die Durchmischungsbewegung von außen exakt verfolgt werden. Aufgrund ihrer Abmessungen kann die Antriebsspule in die Meßspule hineinfahren, so daß die Anordnung besonders kompakt gestaltet werden kann.

In den Rahmen der Erfindung fällt auch ein Verfahren zum Betrieb der erfindungsgemäßen NMR-Meßeinrichtung mit Mischvorrichtung, wie sie oben geschildert wurde, bei dem die Antriebsspule zur Erzeugung einer axialen Auf- und Abbewegung der Stange mit einem niederfrequenten Antriebs-Wechselstrom im Bereich von etwa 0,5 Hz bis 10 Hz, vorzugsweise mit sinusoidaler Amplitude beschickt wird. Die Verwendung einer sinusförmigen Strombeschickung führt zu einer sinusartigen Auslenkungsfunktion der Antriebsspule mit der Stange in axialer Richtung bei Beschickung der Antriebsspule mit Wechselstrom. Erfahrungsgemäß kann die Mischbewegung im angegebenen Frequenzbereich von 0,5 Hz bis 10 Hz am effektivsten erfolgen. Im Gegensatz zu einer beispielsweise dreieckigen oder sägezahnförmigen Bewegungscharakteristik ist das Abfangen der Mischbewegung an den Extrempunkten mit einer sinusförmigen Funktion besonders sanft.

Besonders bevorzugt ist eine Verfahrensvariante, bei der während der NMR-Messung an der Meßprobe kein Strom durch die Antriebsspule geschickt wird. Damit wird in jedem Falle eine negative Einwirkung auf die Homogenität des NMR-Magnetfeldes vermieden.

Bei einer weiteren Verfahrensvariante kann dem niederfrequenten Antriebs-Wechselstrom durch die Antriebsspule ein Gleichstrom zur Einstellung der Ruheposition der Antriebsspule überlagert werden.

Vorteilhaft ist auch eine Verfahrensvariante, bei der während des Stromflusses durch die Antriebsspule die jeweilige Momentanposition derselben mit Hilfe der Meßspule detektiert wird. Auf diese Weise kann die Durchmischungsbewegung von außen beobachtet und überwacht werden.

Bei einer besonders bevorzugten Weiterentwicklung dieser Verfahrensvariante zum Betrieb einer erfindungsgemäßen NMR-Meßeinrichtung mit einer Mischvorrichtung mit Meßspule zur Detektion der momentanen axialen Position der Antriebsspule, wie sie oben geschildert wurde, wird dem niederfrequenten Antriebs-Wechselstrom durch die Antriebsspule ein höherfrequenter weiterer Wechselstrom, vorzugsweise in der Größenordnung von ca. 10 kHz, mit einer im Verhältnis zum niederfrequenten Wechselstrom geringen Amplitude überlagert. Durch die geometrische Ausgestaltung von Antriebsspule und Meßspule sind die beiden Spulen, wenn sie in unmittelbarer Nähe voneinander angeordnet werden, stark miteinander magnetisch gekoppelt. Der dem niederfrequenten Antriebsstrom überlagerte höherfrequente Wechselstrom durch die Antriebsspule hat wegen seiner relativ hohen Frequenz im Verhältnis zur Trägheit der Mischanordnung praktisch keinen Einfluß auf den Antrieb derselben. Er induziert aber in der Meßspule eine Spannung, die vom axialen Abstand zwischen Meß- und Antriebsspule abhängig ist. Die Amplitude des induzierten höherfrequenten Wechselstrom-Signals ist mit ein Maß für die Axialposition der Antriebsspule und dient der genauen Überwachung der Durchmischungsbewegung.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen schematischen Längsschnitt durch eine NMR-Hochdruck-Meßeinrichtung mit erfindungsgemäßer Mischvorrichtung;
- Fig. 2: ein Funktions-Blockschema der NMR-Meßeinrichtung nach Fig. 1;
- Fig. 3a: einen schematischen Längsschnitt durch eine NMR-Hochdruckmeß-Einrichtung mit Kryostaten;
- Fig. 3b: ein vergrößerter Ausschnitt aus Fig. 3a mit schematisch angedeuteter Ruheposition und ausgedehnter Position der erfindungsgemäßen Mischvorrichtung im inhomogenen Magnetfeld;
- Fig. 4a: einen Längsschnitt durch einen NMR-Meßkopf mit axial montierter erfindungsgemäßer Mischvorrichtung;
- Fig. 4b: einen Längsschnitt durch eine Ausführungsform der erfindungsgemäßen Mischvorrichtung;
- Fig. 5: die relative Positionierung von Antriebsspule und Meßspule zur Detektion der axialen Position der Antriebsspule
a) im Ruhezustand der Antriebsspule und
b) im ausgelenkten Zustand der Antriebsspule; und
- Fig. 6: ein Zeitdiagramm des Stromes durch die Antriebsspule.

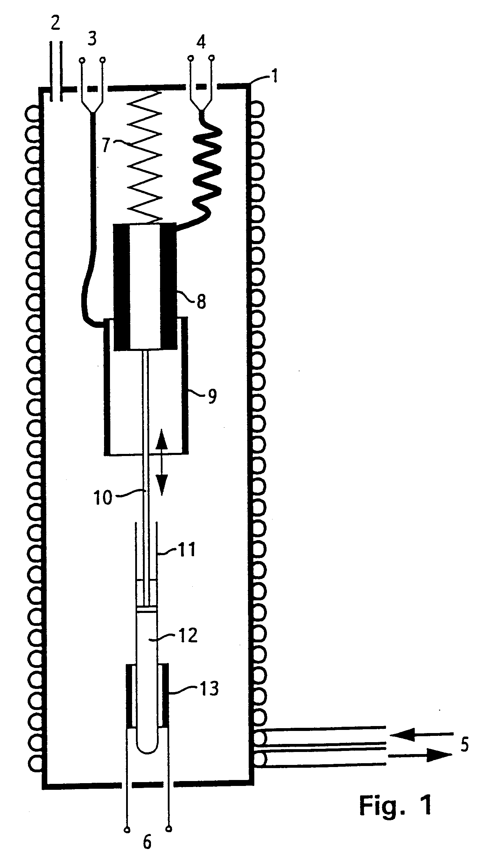

Die schematische Schnittabbildung von Fig. 1 zeigt eine NMR-Hochdruck-Meßeinrichtung mit einem als Hochdruckkammer ausgebildeten Gehäuse 1 und einem zum Zwecke der Druckregelung erforderlichen Zugang 2, an den ein Gaskompressor 20 angeschlossen werden kann. Im unteren Bereich der Hochdruckkammer ist ein Probengläschen 11 mit einer Probenflüssigkeit 12 angeordnet, die sich im Homogentitätszentrum einer in der Zeichnung nicht dargestellten Hauptfeld-Magnetspule befindet, und um die eine NMR-Spule 13 mit Anschlüssen 6 zum Abgreifen von Kernspinresonanz-Signalen aus der Probe angeordnet ist. In das Probengläschen 11 ragt eine axial bewegliche Stange 10 mit einem an ihrem unteren Ende im Probengläschen 11 angeordneten Kolben. Diese ist zum Durchmischen der Probenflüssigkeit 12 sowie darin gelöster oder verwirbelter Gase vorgesehen. Sie wird mit Hilfe einer Antriebsspule 8 bewegt, die in dem als Stator wirkenden inhomogenen Teil des NMR-Magnetfeldes angeordnet und am probenabgewandten Ende mit der Stange 10 verbunden ist. Die Antriebsspule 8 ist durch eine Rückstellfeder 7 mit dem Gehäuse 1 verbunden und zusammen mit der Stange in axialer Richtung beweglich. Die Anschlüsse 4 dienen der Stromzuführung zur Antriebsspule 8.

Weiterhin ist eine Meßspule 9 vorgesehen, deren Innendurchmesser größer ist als der Außendurchmesser der Antriebsspule 8, so daß die Antriebsspule 8 in axialer Richtung in die Meßspule 9 eintauchen kann. Über Anschlüsse 3 werden die von der Bewegung der Antriebsspule 8 in der Meßspule 9 induzierten Ströme bzw. Spannungen nach außen geführt, so daß die Auf- und Abbewegung der Mischvorrichtung von außen beobachtet und überwacht werden kann.

Zur gleichmäßigen Temperierung des Meßraumes ist eine Rohrschlange 5 um das Gehäuse 1 der NMR-Hochdruck-Meßeinrichtung vorgesehen, durch welche ein kühlendes oder erwärmendes Fluid geleitet werden kann.

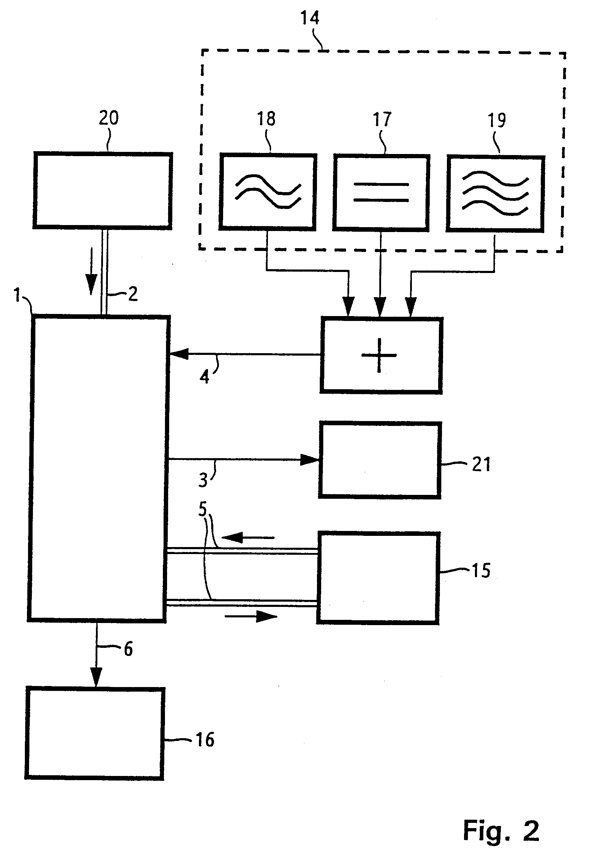

Das in Fig. 2 gezeigte Blockschema zeigt die Funktion der NMR-Meßeinrichtung aus Fig. 1:

Über eine Zugangsleitung 2 wird mit Hilfe eines Gaskompressors 20 der Druck innerhalb des Gehäuses 1 der NMR-Meßzelle konstant gehalten. Eine Temperiereinheit 15 kühlt oder erwärmt über ein durch die Rohrschlange 5 fließendes Fluid die NMR-Meßzelle und damit auch die Meßprobe auf eine konstante Temperatur.

Die während der Meßphasen von der NMR-Spule 13 aufgenommenen Meßsignale werden über die Anschlüsse 6 einem NMR-Detektor zugeführt und danach weiter über einen nicht dargestellten Rechner verarbeitet. Zwischen den Meßphasen wird die Probenflüssigkeit 12 im Probengläschen 11 mit Hilfe der oben beschriebenen Mischvorrichtung durchmischt. Dazu wird aus einem Stromgenerator 14 über die Anschlüsse 4 Strom in die im inhomogenen Teil des NMR-Magnetfeldes angeordnete Antriebsspule 8 geschickt. Dazu wird zunächst, wie unten näher beschrieben, über einen Gleichstromgenerator 17 Gleichstrom in die Antriebsspule 8 geschickt, um deren Ruheposition einzustellen. Mit Hilfe eines Niederfrequenz-Ozillators 18, der einen Wechselstrom mit Frequenzen im Bereich von etwa 0,5 Hz bis 10 Hz erzeugen kann, wird die Antriebsspule 8 zu ihrer linearen Auf- und Abbewegung zum Zwecke des Durchmischens der Probenflüssigkeit 12 angeregt. Aus einem Hochfrequenz-Ozillator 19 schließlich wird die Antriebsspule 8 mit einem im 10-kHz-Bereich liegenden Hochfrequenz-Signal geringer Amplitude beschickt, welches von der in Fig. 1 gezeigten Meßspule 9 detektiert und über die Anschlüsse 3 einem Positionsdetektor 21 zugeführt werden kann, um die Momentanposition der Antriebsspule 8 und damit den zeitlichen Verlauf der Durchmischungsbewegung beobachten zu können.

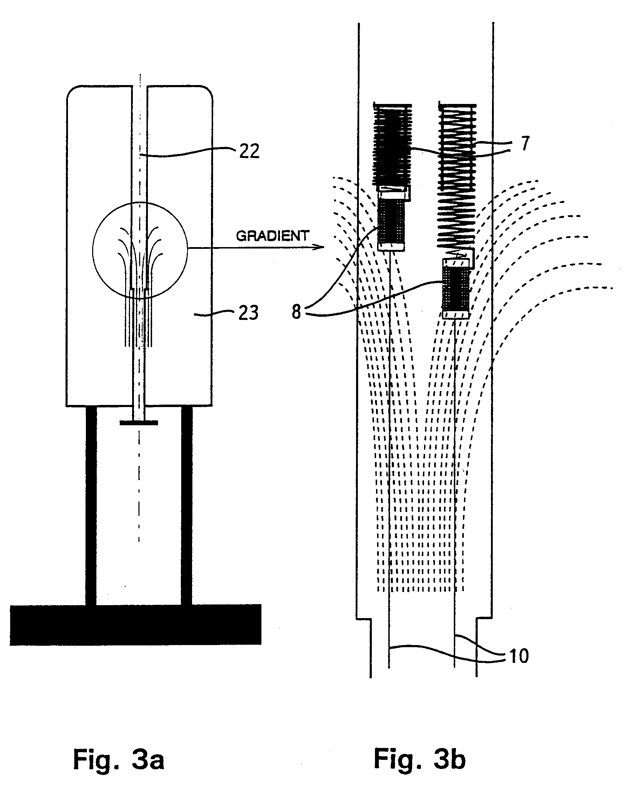

Die erfindungsgemäße Mischvorrichtung ist, wie oben erwähnt, zur Verwendung in NMR-Experimenten vorgesehen, bei denen das zu analysierende Fluidgemisch durchmischt werden muß. Sie wurde als ein fakultatives Hilfsmittel zum Einführen in einen in Fig. 3a schematisch gezeigten 400 MHz supraleitenden Magneten mit schmaler Raumtemperatur-Bohrung 22 in einem Kryostaten 23 entwickelt. Das Grundprinzip des Betriebs ist die Verwendung des Magnetfeld-Gradienten, der sich aufgrund der Richtungsänderung der Magnetfeldlinien um das Magnetzentrum herum befindet.

Die Verwendung des Magnetfeld-Gradienten ist für einen beliebigen Magneten derselben Grundkonstruktion möglich, wenn der Feldgradient präzise angeordnet ist und einige kleine Anpassungen durchgeführt werden. Fig. 3b zeigt einen vergrößerten Ausschnitt aus Fig. 3a mit der Antriebsspule 8 in einer Ruheposition (links) und einer ausgelenkten Position (rechts) innerhalb der angedeuteten gekrümmten Feldlinien des inhomogenen Magnetfeldes.

Der Mischer selbst kann aus einem kleinen PTFE-Sieb bestehen, das mit einer dünnen PTFE und Berylco-Stange verbunden ist. Diese Anordnung schwingt mit einer Amplitude von 25 mm vertikal in dem Glasrohr, das die durch die Kernspinresonanz zu analysierende Lösung enthält.

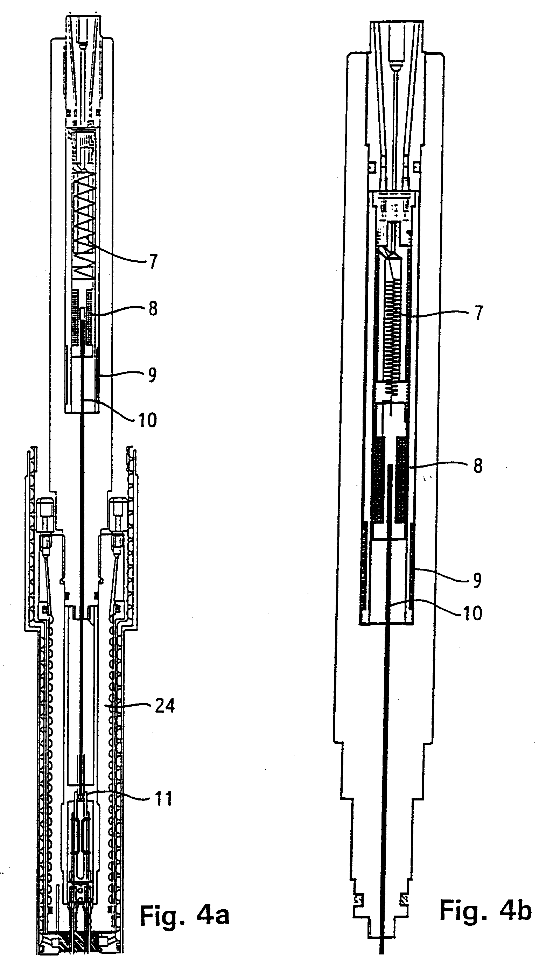

Fig. 4a zeigt einen NMR-Probenkopf 24 mit axial aufmontierter Mischvorrichtung. Der obere Teil der Stange 10 erstreckt sich durch ein 103 mm langes Verlängerungsrohr, das knapp oberhalb des NMR-Probenkopfs 24 angeordnet ist und mündet in den Motorzwischenraum.

Die zwei Hauptteile, d.h. das Verlängerungsrohr und der Motorzwischenraum sind Berylco-Zylinder. Das Innere dieser Teile ist mit dem Inneren des NMR-Probenkopfes 24 verbunden, so daß das ganze System unter Druck gesetzt werden kann. Die Mischvorrichtung kann entfernt werden und durch einen Stopfen oben am NMR-Probenkopf 24 ersetzt werden. Eine andere mögliche Ausführungsform der erfindungsgemäßen Mischvorrichtung ist in Fig. 4b gezeigt.

Der Motor ist durch ein Kabel mit einem elektronischen Niederfrequenz-Sinuswellen-Generator verbunden. Dieser Oszillator 18 wurde speziell für den vorliegenden Anwendungszweck konstruiert und ist mit einem dynamischen Indikator ausgerüstet, der kontinuierlich die Bewegung des Mischers zeigt.

Der Mischer kann während langen Experimenten durch Fernsteuerung von einem Computer aus gestartet und gestoppt werden.

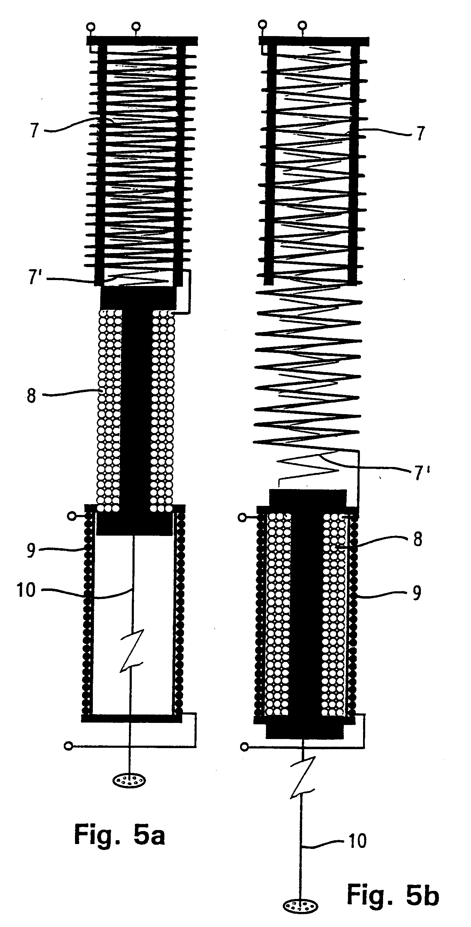

Der Motor besteht aus der Antriebsspule 8, die durch zwei Federn aufgehängt ist, die auch die elektrische Verbindung herstellen, wie in Fig. 5a und Fig. 5b angedeutet ist. Die zentrale Feder 7' aus isoliertem Kupfer mit einem Durchmesser von 0,2 mm hat eine geringe Stärke und dient nur als elektrischer Leiter. Ihr äußerer Durchmesser beträgt 4,5 mm und ihre Länge in der in Fig. 5a gezeigten Ruhestellung beträgt 44 mm. Die äußere Rückstellfeder 7 besteht aus Berylco (nicht isoliert) mit einem Durchmesser von 0,5 mm. Sie stellt nicht nur die elektrische Verbindung her, sondern hält die mobile Motorstangen-Siebanordnung und hat folgende Abmessungen: Äußerer Durchmesser 10 mm, 65 Windungen, Länge bei Ruhestellung 35 mm. Eine Bewegung wird durch eine variable Sinusspannung mit geringer Frequenz erreicht.

Die Antriebsspule 8 ist mit Kupferdraht von einem Durchmesser von 0,2 mm gewickelt und hat im gezeigten Ausführungsbeispiel die folgenden Abmessungen: Innendurchmesser 6 mm, Außendurchmesser 10 mm, Länge 25 mm.

Die Kraft auf die Antriebsspule wird an dem Ort am größten, wo das Produkt axiale Feldkomponenten mal axialer Feldgradient des Magneten maximal wird. Beispielsweise bei einem bestimmten 400 MHz Magneten mit 52 mm Raumtemperaturbohrung befindet sich dieser Ort etwa 220 mm in axialer Richtung vom magnetischen Zentrum entfernt. Der Verlauf der Kraft um diesen Ort herum ist ziemlich flach über eine bestimmte Länge, z. B. innerhalb 5 % über eine Länge von 30 mm.

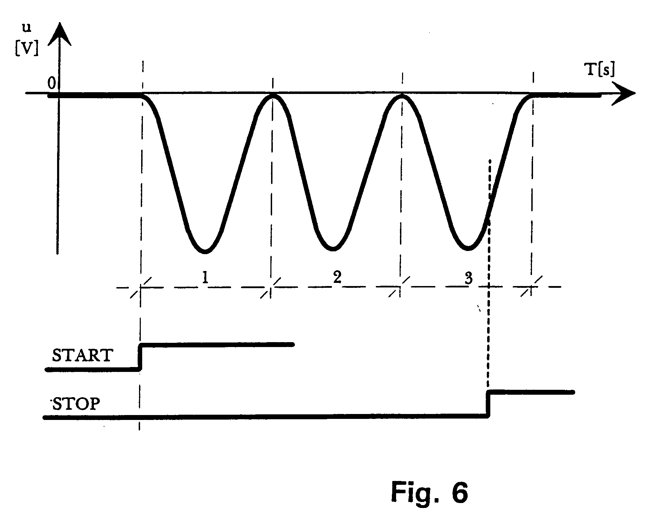

Um die Kraft auf die Antriebsspule maximal auszunützen, muß sich das Zentrum der Antriebsspule während des Mischvorganges innerhalb des flachen Bereiches der Kraftkurve bewegen. Zudem sollte nach dem Abschalten des Mischvorganges der Kolben der Stange 10 am oberen Rand der Probenflüssigkeit 12 zur Ruhe kommen. Beides erreicht man, indem das Zentrum der Antriebsspule 8 im Ruhezustand ca. 1 cm oberhalb des Ortes maximaler Kraft plaziert wird, indem mit Hilfe eines Gleichstromes in der Antriebsspule ihr Zentrum an den Ort maximaler Kraft verschoben wird, und schließlich indem mit Hilfe eines sinusförmigen Wechselstromes in der Antriebsspule die Mischbewegung über eine Strecke von ca. ± 1,3 cm erzeugt wird. Die Überlagerung des Gleich- und Wechselstromanteiles kann als einzelnes Signal aufgefaßt werden, wie in Fig. 6 dargestellt.

Die Kraftkurve wurde unter Verwendung eines Prototyps mit einer Feder 7 und einer Antriebsspule 8, die mit einer langen von dem Boden des Magneten vorstehenden Stange 10 mit einem Durchmesser von 0,8 mm befestigt ist, gemessen. Diese dünne Stange erstreckt sich durch ein Glasführungsrohr von einem inneren Durchmesser von 6 mm.

Eine Gleichspannung von 2 V wird an die Spule angelegt und die durch diese Spannung bei verschiedenen Höhen erzeugte Bewegung der Stange wird gemessen.

Eine zweite stationäre rohrförmige Meßspule 9, die direkt unterhalb der Antriebsspule 8 angeordnet ist, wird zum Messen der Bewegung verwendet.

Ein Signal mit hoher Frequenz (10 kHz) und kleiner Amplitude (100 mV) wird dem Sinus-Signal an der mobilen Anstriebsspule 8 additiv überlagert. Dieses hochfrequente Signal induziert ein Sinussignal von 10 KHz in der stationären Meßspule 9, dessen Amplitude ungefähr proportional zu der räumlichen Überlappung der zwei Spulen ist. Diese Art der Detektion hat den Vorteil, daß sie eine praktisch lineare kontinuierliche Messung der Verschiebung liefert. Die stationäre Antriebsspule 8 besteht aus zwei Wickellagen mit folgenden Abmessungen: Durchmesser 12 mm, Drahtdurchmesser 0,2 mm, Länge der Spule 25 mm.

Diese Anordnung ist sehr einfach und besteht nur aus zwei Spulen und vier elektrischen Verbindungen. Es gibt keine ferromagnetischen Komponenten. Die Mischvorrichtung ist für Temperaturen bis maximal 180°C ausgelegt.

Die Mischvorrichtung ist mit der Elektronik mittels eines abgeschirmten Kabels mit 4 Leitern verbunden. Aus technischen Gründen ist die Erde für das Netz und für das von der Meßspule 9 detektierte Signal mit dem Gehäuse der Elektronikeinheit verbunden. Diese Erde ist jedoch nicht mit dem Magnetgehäuse 1 verbunden. Die Signale in den zwei Spulen sind deshalb nicht geerdet. Sie haben keine gemeinsame Erde aufgrund der großen Differenz im Strom durch die beiden Spulen. Aus diesem Grund sind eher 4 als 3 elektrische Verbindungsstücke erforderlich.

Die Elektronik wurde entwickelt, um zwei Aufgaben zu lösen:
a) Bereitstellen eines Niederfrequenz-Sinussignal-Generators, der die folgende Auswahl erlaubt:
   - Frequenzen von 0,5 Hz bis 10 Hz
   - Amplituden bis zu 2V von Spitze zu Spitze
   - Positionierung der Antriebsspule über eine kontinuierliche Offset-Spannung

   Die letztere Einstellung ist sehr wichtig; man kann dadurch die Reibung an den Endpunkten der Bewegung kompensieren und somit die Arbeitsweise des Mischers optimieren.
b) Da das ganze System (unter Druck) vollständig geschlossen sein wird und nicht eingesehen werden kann, ist es erforderlich, zu wissen, ob der Mischer arbeitet und wie die Amplitude seiner Bewegung ist. Wenn sich die Viskosität des untersuchten Produkts ändert, muß die Amplitude neu eingestellt werden können, während ihre Wirkung verifiziert wird. Um diesen Anforderungen zu genügen, wurde ein Bewegungs-Detektiersystem entwickelt.

Es ist vorteilhaft, die Bewegung an der Spitze einer Sinuskurve zu starten und zu stoppen, wie in Fig. 6 gezeigt ist, um ein Verschütten der Probenflüssigkeit 12 aus dem Probengläschen 11 oder die Bildung einer Blockage oberhalb der Mischung zu verhindern.

Der Niederfrequenz-Oszillator 18 ist für digitale Verarbeitung eingerichtet. Es wird eine in einem EPROM-Speicherchip gespeicherte Cosinus-Welle verwendet. Auf den Speicherchip folgt ein Digital-Analog-Umsetzer. Wenn der Operator START drückt, wird der Speicher kontinuierlich gelesen und gibt somit ein sinusförmiges Signal beim Start und Stop. Dieser Betriebsmodus hat den Vorteil, daß beim Starten und Stoppen ein perfekt synchronisiertes Signal erzeugt wird.

### BEZUGSZEICHENLISTE

- 1: Gehäuse
- 2: Zugang zur Hochdruckkammer
- 3: Anschlüsse der Meßspule
- 4: Anschlüsse der Antriebsspule
- 5: Rohrschlange für die Temperierung
- 6: Anschlüsse der NMR-Spule
- 7: Rückstellfeder
- 7': Kontaktfeder
- 8: Antriebsspule
- 9: Meßspule
- 10: Stange mit Kolben
- 11: Probengläschen
- 12: Probenflüssigkeit
- 13: NMR-Spule
- 14: Stromgenerator
- 15: Temperiereinheit
- 16: NMR-Detektor
- 17: Gleichstromgenerator
- 18: Niederfrequenz-Oszillator
- 19: Hochfrequenz-Osziallator
- 20: Gaskompressor
- 21: Positionsdetektor
- 22: Raumtemperatur-Bohrung
- 23: Kryostat
- 24: NMR-Probenkopf

## Patentansprüche

1. Kernspinresonanz (NMR)-Meßeinrichtung mit einer Hauptfeld-Magnetspule zur Erzeugung eines parallel zu einer zentralen Achse der Hauptfeld-Magnetspule verlaufenden homogenen statischen Magnetteldes in einem Meßvolumen innerhalb der Meßprobe und mit einer Mischvorrichtung zum Durchmischen von insbesondere flüssigen und/oder gasförmigen Meßproben, die eine koaxial zur zentralen Achse der Hauptfeld-Magnetspule angeordnete und in axialer Richtung der zentralen Achse bewegliche Stange (10) enthält, die an ihrem einen Ende einen in die flüssige und/oder gasförmige Meßprobe ragenden Kolben aufweist, und die mit Hilfe einer mit ihrem von der Meßprobe abgewandten Ende verbundenen Antriebsspule (8) bei Stromdurchfluß durch die Antriebsspule (8) in axialer Richtung bewegt wird, wobei ein Federelement (7) vorgesehen ist, welches die Stange (10) in eine Ruheposition zurückt reibt,
dadurch gekennzeichnet,
daß die Antriebsspule (8) axialsymmetrisch ist und koaxial mit der zentralen Achse der Hauptfeld-Magnetspule außerhalb des Meßvolumens angeordnet, mit Hilfe des Federelementes (7) koaxial zur zentralen Achse der Hauptfeld-Magnetspule beweglich befestigt und starr mit der Stange (10) verbunden ist, wobei die stromdurchflossene Antriebsspule (8) durch eine Kraft bewegt wird, die die axiale Komponente des von der Hauptfeld-Magnetspule erzeugten Magnetfeldes in Verbindung mit einem axialen Feldgradienten auf die Antriebsspule (8) ausübt.

2. NMR-Meßeinrichtung nach Anspruch 1, dadurch gekennzeichnet, daß das Gehäuse (1) eine Hochdruckkammer bildet, und daß die Mischvorrichtung ebenso wie die Meßprobe im Hochdruckbereich der Hochdruckkammer angeordnet ist.

3. NMR-Meßeinrichtung nach Anspruch 1 oder 2, dadurch gekennzeichnet, daß einer der beiden zur Stromversorgung der Antriebsspule (8) erforderlichen elektrischen Anschlüsse (4) durch das Federelement (7) gebildet wird.

4. NMR-Meßeinrichtung nach einem der vorhergehenden Ansprüche, dadurch gekennzeichnet, daß das Federelement (7) eine Rückstellfeder ist und daß die Antriebsspule (8) bei Stromdurchfluß die Rückstellfeder (7) vom Gehäuse (1) wegzieht und dadurch spannt.

5. NMR-Meßeinrichtung nach einem der vorhergehenden Ansprüche, dadurch gekennzeichnet, daß koaxial zur Antriebsspule (8) eine Meßspule (9) zur Detektion der momentanen axialen Position der Antriebsspule (8) vorgesehen ist.

6. Verfahren zum Betrieb einer Mischvorrichtung in einer NMR-Meßeinrichtung nach einem der vorhergehenden Ansprüche, dadurch gekennzeichnet, daß die Antriebsspule (8) zur Erzeugung einer axialen Auf- und Abbewegung der Stange (10) mit einem Antriebs-Wechselstrom, vorzugsweise mit sinusoidaler Amplitude beschickt wird.

7. Verfahren nach Anspruch 6, dadurch gekennzeichnet, daß während der NMR-Messung an der Meßprobe kein Strom durch die Antriebsspule (8) geschickt wird.

8. Verfahren nach Anspruch 6 oder 7, dadurch gekennzeichnet, daß dem Antriebs-Wechselstrom durch die Antriebsspule (8) ein Gleichstrom zur Einstellung der Ruheposition der Antriebsspule (8) überlagert wird.

9. Verfahren nach einem der Ansprüche 6 bis 8 zum Betrieb einer Mischvorrichtung in einer NMR-Meßeinrichtung nach Anspruch 5, dadurch gekennzeichnet, daß während des Stromflusses durch die Antriebsspule (8) die jeweilige Momentanposition derselben mit Hilfe der Meßspule (9) detektiert wird.

10. Verfahren nach Anspruch 9, dadurch gekennzeichnet, daß dem Antriebs-Wechselstrom durch die Antriebsspule (8) ein weiterer Wechselstrom von höherer Frequenz, vorzugsweise in der Größenordnung von 10 kHz und vorzugsweise mit einer geringeren Amplitude als der des niederfrequenten Antriebs-Wechselstromes überlagert wird.

11. Verfahren nach einem der Ansprüche 6 bis 10, dadurch gekennzeichnet, daß der Antriebs-Wechselstrom Frequenzen im Bereich von 0,5 Hz bis 10 Hz aufweist.

## Claims

1. Nuclear magnetic resonance (NMR) measuring means comprising a main field magnet coil for generating, in a measuring volume within the measuring sample, a homogeneous static magnetic field extending in parallel to a central axis of the main field magnet coil, and a mixing device for the mixing of, in particular liquid and/or gaseous measuring samples, the mixing device comprising a rod (10) arranged coaxially to the central axis of the main field magnet coil being movable in the axial direction of the central axis and comprising at one end a piston projecting into the liquid and/or gaseous measuring sample and being moved by means of a drive coil (8), connected to its end facing away from the measuring sample, in the axial direction when a current is flowing through the drive coil (8), wherein a spring element (7) is provided which drives the rod (10) back to a rest position,
characterized in that
the drive coil (8) is symmetrical to its axis and arranged coaxially with the central axis of the main field magnet coil outside of the measuring volume, is fastened in a movable manner by means of the spring element (7) coaxially to the central axis of the main field magnet coil, and connected rigidly with the rod (10), wherein the drive coil (8) through which a current flows, is moved by a force exerted onto the drive coil (8) by the axial component of the magnetic field generated by the main field magnet coil in connection with an axial field gradient.

2. NMR measuring means according to claim 1, characterized in that the housing (1) forms a high pressure chamber and that the mixing device as well as the measuring sample is arranged in the high pressure region of the high pressure chamber.

3. NMR measuring means according to claim 1 or 2, characterized in that one of the two electrical connections (4) required for current supply of the drive coil (8) is formed by the spring element (7).

4. NMR measuring means according to one of the preceding claims, characterized in that the spring element (7) is a restoring spring and that the drive coil (8) pulls the restoring spring (7) away from the housing (1) when current passes through it to tension the restoring spring (7).

5. NMR measuring means according to one of the preceding claims, characterized in that a measuring coil (9) is provided coaxial to the drive coil (8) for detecting the instantaneous axial position of the drive coil (8).

6. Method of operating a mixing device in an NMR measuring means according to one of the preceding claims, characterized in that the drive coil (8) is supplied with an alternating drive current, preferably with a sinusoidal amplitude, for generating an axial up-and-down motion of the rod (10).

7. Method according to claim 6, characterized in that no current flows through the drive coil (8) during the NMR measurement of the measuring sample.

8. Method according to claim 6 or 7, characterized in that the alternating drive current through the drive coil (8) is overlapped with a direct current for adjusting the rest position of the drive coil (8).

9. Method according to one of claims 6 through 8 for operating a mixing device in an NMR measuring means according to claim 5, characterized in that the corresponding instantaneous position of the drive coil (8) is detected by means of the measuring coil (9) when current is flowing through same.

10. Method according to claim 9, characterized in that the alternating drive current through the drive coil (8) is overlapped with a further alternating current of higher frequency, preferably of the order of 10 kHz and preferably with an amplitude which is smaller than that of the low frequency alternating drive current.

11. Method according to one of claims 6 through 10, characterized in that the alternating drive current comprises frequencies in the range of 0.5 Hz to 10 Hz.

## Revendications

1. Dispositif de mesure par résonance magnétique nucléaire (RMN), comportant une bobine magnétique de production du champ principal pour produire, dans un volume de mesure à l'intérieur de l'éprouvette de mesure, un champ magnétique homogène statique orienté parallèlement à un axe central de la bobine magnétique de production du champ principal, ainsi que, pour mélanger à fond des éprouvettes de mesure, en particulier sous forme liquide et/ou gazeuse, un dispositif de mesure qui contient une tige (10) qui est disposée coaxialement à l'axe central de la bobine magnétique de production du champ principal, qui est mobile selon la direction axiale de l'axe central, qui, à sa première extrémité, présente un piston pénétrant dans l'éprouvette de mesure sous forme liquide et/ou gazeuse, et qui, à l'aide d'une bobine d'entraînement (8) reliée à son extrémité opposée à l'éprouvette de mesure, lorsqu'un courant électrique passe à travers la bobine d'entraînement (8), se déplace selon la direction axiale, un élément élastique (7) étant prévu pour rappeler la tige (10) en position de repos,
caractérisé par le fait,
que la bobine d'entraînement (8) présente une symétrie axiale, qu'elle est disposée à l'extérieur du volume de mesure, coaxialement à l'axe central de la bobine magnétique de production du champ principal, qu'à l'aide de l'élément élastique (7), elle est fixée avec liberté de se déplacer coaxialement à l'axe central de la bobine magnétique de production du champ principal et qu'elle est rigidement reliée à la tige (10), la bobine d'entraînement (8), parcourue par le courant électrique, se déplaçant sous l'action d'une force qu'exerce sur la bobine d'entraînement (8) la composante axiale du champ magnétique produit par la bobine magnétique de production du champ principal, en liaison avec un gradient axial du champ.

2. Dispositif de mesure par résonance magnétique nucléaire selon la revendication 1, caractérisé par le fait que le carter (1) forme une chambre sous haute pression et que le dispositif de mélange est disposé, de même que l'éprouvette de mesure, dans la zone sous haute pression de la chambre sous haute pression.

3. Dispositif de mesure par résonance magnétique nucléaire selon la revendication 1 ou 2, caractérisé par le fait que l'un des deux raccords électriques (4) nécessaires pour l'alimentation de la bobine d'entraînement (8) en courant électrique est formé par l'élément élastique (7).

4. Dispositif de mesure par résonance magnétique nucléaire selon l'une des revendications précédentes, caractérisé par le fait que l'élément élastique (7) est un ressort de rappel et que, lors du passage du courant électrique, la bobine d'entraînement (8) écarte du carter le ressort de rappel (7) et le contraint de ce fait.

5. Dispositif de mesure par résonance magnétique nucléaire selon l'une des revendications précédentes, caractérisé par le fait que coaxialement à la bobine d'entraînement (8) est prévue une bobine de mesure (9) pour détecter la position axiale momentanée de la bobine d'entraînement (8).

6. Procédé d'entraînement d'un dispositif de mélange dans un dispositif de mesure par résonance magnétique nucléaire conforme à l'une des revendications précédentes, caractérisé par le fait que pour produire un mouvement axial de monte et baisse de la tige (10), la bobine d'entraînement (8) est alimentée en un courant alternatif d'entraînement, de préférence d'amplitude sinusoïdale.

7. Procédé selon la revendication 6, caractérisé par le fait que pendant la mesure par résonance magnétique nucléaire sur l'éprouvette de mesure aucun courant ne passe dans la bobine d'entraînement (8).

8. Procédé selon la revendication 6 ou 7, caractérisé par le fait qu'au courant alternatif d'entraînement passant dans la bobine d'entraînement (8), se superpose un courant continu pour prescrire la position de repos de la bobine d'entraînement (8).

9. Procédé selon l'une des revendications 6 à 8, pour l'entraînement d'un dispositif de mélange dans un dispositif de mesure par résonance magnétique nucléaire conforme à la revendication 5, caractérisé par le fait que pendant le passage du courant électrique dans la bobine d'entraînement (8), sa position momentanée respective est détectée à l'aide de la bobine de mesure (9).

10. Procédé selon la revendication 9, caractérisé par le fait qu'au courant alternatif d'entraînement passant dans la bobine d'entraînement (8) se superpose un autre courant alternatif de fréquence plus élevée, de préférence de l'ordre de grandeur de 10 kHz, et de préférence d'une amplitude inférieure à celle du courant alternatif d'entraînement à basse fréquence.

11. Procédé selon l'une des revendications 6 à 10, caractérisé par le fait que le courant alternatif d'entraînement présente des fréquences sur la plage de 0,5 Hz à 10 Hz.
